(19) Europäisches Patentamt
European Patent Office
Office européen des brevets

(11) **EP 4 700 414 A1**

(12) **EUROPÄISCHE PATENTANMELDUNG**

(43) Veröffentlichungstag:
**25.02.2026 Patentblatt 2026/09**

(21) Anmeldenummer: **24195582.2**

(22) Anmeldetag: **21.08.2024**

(51) Internationale Patentklassifikation (IPC):
**G01R 31/42** (2006.01) **H02M 1/32** (2007.01)

(52) Gemeinsame Patentklassifikation (CPC):
**G01R 31/42; H02M 1/32**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder:
• **Siemens Aktiengesellschaft**
  **80333 München (DE)**
• **Karlsruher Institut für Technologie**
  **76131 Karlsruhe (DE)**

(72) Erfinder:
• **Hiller, Marc**
  **75015 Bretten (DE)**
• **Köllensperger, Peter**
  **90562 Heroldsberg (DE)**
• **Liske, Andreas**
  **76327 Pfinztal (DE)**
• **Tsotoulidis, Savvas**
  **35132 Lamia (GR)**

(74) Vertreter: **Siemens Patent Attorneys**
  **Postfach 22 16 34**
  **80506 München (DE)**

(54) **DATENBASIERTES CONDITION MONITORING VERFAHREN ZUR ÜBERWACHUNG NETZSEITIGER KOMPONENTEN**

(57) Die Erfindung betrifft ein Computer-implementiertes Verfahren, eine Computer-implementierte Vorrichtung, ein Computerprogrammprodukt und ein System zum Bestimmen eines Degradationsfortschritts einer auf einen Stromrichter und/oder Zwischenkreis folgenden Last umfassend Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist, Bestimmen einer Amplitude zumindest einer höheren Harmonischen einer Grundschwingung des erfassten zeitlichen Verlaufs, Vergleichen der Amplitude mit einer Referenzamplitude, wobei die Referenzamplitude mit einem bekannten Degradationsfortschritt der Last assoziiert ist und Bestimmen des Degradationsfortschritts der Last basierend auf dem Vergleichen.

FIG 8

**Beschreibung**

Die vorliegende Erfindung betrifft ein Computer-implementiertes Verfahren, eine Computer-implementierte Vorrichtung, ein System sowie ein Computerprogrammprodukt zum Bestimmen eines Degradationsfortschritts einer auf einen Stromrichter und/oder Zwischenkreis folgenden Last.

Elektrische Bauteile unterliegen im Allgemeinen einem Alterungsprozess. Diese können z.B. durch wiederholtes Erwärmen und Abkühlen der betreffenden Bauteile im Regelbetrieb verursacht werden, durch im Material der elektrischen Bauteile vorhandene Materialdefekte, etc. Dies Alterungsprozess führt zu einer in der Regel begrenzten Lebenszeit der betreffenden Bauteile, welche folglich nach einer gewissen Einsatzzeit ausgetauscht werden müssen.

In einigen Fällen kann auch in elektrischen Antriebssystemen durch deren Benutzung eine Alterung auftreten. Diese Alterung kann z.B. durch eine Verringerung eines Rotorflusses durch eine Degradation von Magneten eines elektrischen Antriebssystems und/oder eine Erhöhung des Widerstands einer Rotorwicklung auftreten. In einigen Fällen kann sich auch ein Übergangswiderstand an einer Kontaktstelle des Rotors (z.B. eines elektrisch leitenden Übergangs vom Stator hin zum Rotor) vergrößern. Diese Alterungseffekte können sich auf das Verhalten des elektrischen Antriebsmittels auswirken und damit auch auf die Eigenschaften der verwendeten Regelung, um z.B. sicherzustellen, dass einem elektrischen Antrieb stets eine gewünschte Versorgungsspannung bzw. ein gewünschter Versorgungsstrom zur Verfügung gestellt wird.

Die verbleibende Lebenszeit von Komponenten in einem zuvor genannten System (z.B. in einem Stromrichter und/oder einem elektrischen Antriebsmittel) kann für einen Anlagenbetreiber häufig schwer zu ermitteln sein. Das Bestimmen einer zu verbleibenden Lebenszeit kann sowohl für einen Hersteller des jeweiligen elektrischen Bauteils als auch für einen Systemadministrator, welcher für eine Implementierung des jeweiligen elektrischen Bauteils zuständig ist, eine Herausforderung darstellen. Hersteller führen diesbezüglich häufig offline Berechnungen durch, um eine zu erwartete Lebenszeit eines Bauteils (z.B. eines Leistungswandlers) zu bestimmen und führen diese dann in ihren Dokumentationen auf. Diese Berechnungen basieren meist auf Lastprofilen und Produktnutzung, wie sie über einen idealen Produktzyklus hinweg auftreten kann, während typische Randbedingungen in Betracht gezogen werden, wie z.B. Temperatur, Feuchtigkeit, Höhe, etc.

Die Ermittlung der verbleibenden Lebenszeit kann z.B. durch eine regelmäßige Wartung der betreffenden Komponenten erfolgen. In einem derartigen Fall können z.B. zwei Wartungsstrategien in Frage kommen. Es ist ggf. möglich, basierend auf den bekannten Lastprofilen und spezifizierten Umgebungsbedingungen Wartungsintervalle festzulegen, zu deren Zeitpunkten die zu wartenden Komponenten mit hoher Wahrscheinlichkeit noch funktionstüchtig sind. Die Wahl dieser Wartungsintervalle kann jedoch häufig dazu führen, dass Komponenten mit ggf. noch beträchtlicher verbliebener Lebenszeit ausgetauscht werden, was zu (unnötig) hohen Kosten und Materialeinsatz führen kann.

Als weitere Wartungsstrategie, falls Stillstandzeiten des elektrischen Systems in Kauf genommen werden können, kann auch ein Austausch der betreffenden Komponente erfolgen, genau dann, wenn diese auch tatsächlich ausgefallen ist. Dies kann zwar die mit einem zu frühen Austausch verbundenen (unnötigen) Kosten verringern, jedoch kann demgegenüber ein unerwarteter Stillstand des elektrischen Systems erfolgen und dadurch z.B. eine Produktionslinie stilllegen. Je nach dadurch aufgetretenem Defekt kann dies zu unerwartet hohen Kosten führen. Die Auswahl, der für die betreffende Anlage und Applikation optimierten Wartungsintervalle kann zu einer globalen Kostenreduktion und zu einer Minimierung der Stillstandzeit des elektrischen Systems führen.

Durch den Einsatz sog. Condition Monitoring Verfahren kann der Zeitpunkt, wann eine Wartung des elektrischen Systems durchgeführt werden soll, optimiert werden, indem die verbliebene Lebenszeit der elektrischen Komponenten bzw. ein Fortschritt eines aktuellen Degradationsprozesses ermittelt wird.

Allgemein kann das Condition Monitoring in drei unterschiedliche Klassen von Ansätzen unterteilt werden: Im Rahmen der sensorbasierten Condition Monitoring Systeme kann zusätzliche/dedizierte Sensorik und/oder komplexe Messschaltungen verwendet werden, um direkt Größen eines elektrischen Systems zu messen, welche Rückschlüsse auf einen aktuellen Degradationsfortschritt elektrischer Komponenten ermöglichen. Die Komplexität und auch die Implementierungskosten eines derartigen Systems können dabei deutlich steigen. Unterschieden werden kann weiter zwischen Messsystemen, die online im Betrieb eines Stromrichtersystems eingesetzt werden und externer Prüftechnik, die lediglich in festgelegten (vorbestimmten) Intervallen zur Messung verwendet wird.

Im Rahmen modellbasierter Condition Monitoring Systeme wird versucht, einige der vorstehend genannten Probleme zumindest teilweise durch Modellbildung zu überwinden. In diesen Modellen wird der Alterungsvorgang physikalisch oder stochastisch implementiert. Das Modell wird anschließend online im Betrieb mit Lastprofilen und Umgebungsbedingungen als Eingangsvariablen betrieben. Das Ergebnis kann eine stochastische Bewertung der verbliebenen Lebenszeit bzw. des aktuellen Schweregrads der Schädigung sein. Trotz des Wegfalls zusätzlicher Messschaltungen besteht die Herausforderung dennoch in einem Modellaufbau mit ausreichender Güte.

Datenbasierte Condition Monitoring Systeme können derart eingerichtet sein, aus bestehenden Mess- und Zustandsgrößen Muster, die Rückschlüsse auf die Änderung eines Degradationsindikators ermöglichen und damit Rückschlüsse auf eine eingetretene Alterung ermöglichen. Hierbei kann der Informationsgehalt von verschiedenen möglichen Messsignalen und Zustandsgrößen analysiert werden sowie auf Möglichkeiten der Signalverarbeitung zurückgegriffen werden. Dies kann basierend auf statistischen Methoden erfolgen oder basierend auf Methoden der künstlichen Intelligenz.

Bekannte Condition Monitoring Verfahren ermöglichen jedoch noch nicht unter allen Umständen eine zufriedenstellende Bestimmung eines Degradationsfortschritts, da diese zu komplexe Hardware, eine zu komplexe Modellbildung oder eine aufwendige Datenanalyse erfordern. In einigen Fällen, sind derzeit verwendete Condition Monitoring Verfahren für den Feldeinsatz schlicht zu ungenau.

Es ist möglich, das Condition Monitoring eines Stromrichters, z.B. bei Vorliegen eines (elektrischen) Antriebs auf das Erfassen von mechanischen Vibrationen und/oder elektrischer Signale, welche mit dem Betrieb des Antriebs assoziiert sind, zu basieren. Eine Möglichkeit in diesem Zusammenhang kann der Rückgriff auf eine motor current signature analysis (MCSA) sein, welche z.B. angewendet wird, um mechanische Fehler eines Antriebs zu identifizieren, wie z.B. eine Fehlausrichtung, Ungleichgewicht, lockere Füße des Motors, Kavitationseffekte (z.B. bei Pumpen) etc. Dies stützt sich jedoch im Wesentlichen auf die Auswertung mechanischer Parameter und kann daher nicht in allen Fällen eine erwünschte Vorhersagegenauigkeit sicherstellen.

Da in einigen Fällen die Stromrichter schwer zugänglich sein können (z.B. bei Offshore-Windparks), kommt dem Condition Monitoring eine besondere Bedeutung zu. In einigen Fällen kann ein Stromrichter auch zum Einspeisen elektrischer Leistung in ein Stromnetz verwendet werden.

Eine Degradation oder ein sonstiges unerwünschtes Verhalten eines Stromnetzes wird dabei in der Regel nicht berücksichtigt bzw. charakterisiert. Zur Charakterisierung eines Stromnetzes werden meist Grenzwerte des Stromnetzes wie z.B. eine Netzspannung und/oder eine Frequenz des Stromnetzes im Toleranzband (z.B. ca. 48-52 Hz) überwacht. Die Stabilisierung einer netzseitigen Stromregelung (z.B. des Stromnetzes) erfolgt dabei meist durch die Auslegung einer robusten Phase-Locked-Loop (PLL), welche sowohl für starke als auch für schwache Netze stabil bleibt. Die Dynamik der Regelung wird dahingegen reduziert, dass ein stabiler Betrieb über den gesamten Betriebsbereich erreicht wird.

Mit derzeitigen Condition Monitoring Verfahren ist insbesondere die Charakterisierung einer Last, welche z.B. einem Stromrichter folgt meist nicht möglich oder zumindest nicht in einem zufriedenstellenden Ausmaß möglich.

Es besteht daher ein Bedarf ein verbessertes Condition Monitoring Verfahren bereitzustellen, welches die Nachteile und Einschränkungen derzeit verwendeter Condition Monitoring Verfahren zumindest teilweise überwindet.

Die vorliegende Erfindung stellt sich daher die technische Aufgabe ein verbessertes und leicht bzw. kostengünstig zu implementierendes Condition Monitoring Verfahren bereitzustellen, welches insbesondere ein Bestimmen eines Degradationsfortschritts einer auf einen Stromrichter und/oder Zwischenkreis folgenden Last ermöglicht.

Gemäß eines ersten Aspekts der vorliegenden Erfindung wird ein Computer-implementiertes Verfahren zum Bestimmen eines Degradationsfortschritts einer auf einen Stromrichter und/oder Zwischenkreis folgenden Last vorgeschlagen. Das Computer-implementierte Verfahren kann ein Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist umfassen sowie ein Bestimmen einer Amplitude zumindest einer höheren Harmonischen einer Grundschwingung des erfassten zeitlichen Verlaufs. Ferner kann das Computer-implementierte Verfahren ein Vergleichen der Amplitude mit einer Referenzamplitude umfassen, wobei die Referenzamplitude mit einem bekannten Degradationsfortschritt der Last assoziiert ist sowie ein Bestimmen des Degradationsfortschritts der Last basierend auf dem Vergleichen.

Unter einem Degradationsfortschritt kann vorliegend ein Voranschreiten eines Alterungsprozesses des Stromrichters (hierin auch als Umrichter bezeichnet) und/oder des elektrischen Antriebsmittels verstanden werden. Ein Voranschreiten der Degradation kann mit einer ansteigenden Ausfallwahrscheinlichkeit des Stromrichters und/oder des elektrischen Antriebsmittels (z.B. durch einen Defekt) assoziiert sein. Der zeitliche Verlauf kann zu vorbestimmten (diskreten) Zeitpunkten erfasst werden und/oder kann kontinuierlich während des Betriebs des Stromrichters und/oder des elektrischen Antriebsmittels erfasst werden.

Der erfasste zeitliche Verlauf kann sich über eine Dauer von weniger als einer Sekunde erstrecken. In einigen Fällen kann sich der erfasste zeitliche Verlauf über eine Sekunde bis zehn Sekunden erstrecken, in einigen Fällen über eine Dauer von elf Sekunden bis 30 Sekunden, in weiteren Fällen über eine Dauer von 31 Sekunden bis zu 60 Sekunden. In weiteren Fällen kann sich die Dauer auch über mehrere Minuten erstrecken (z.B., zwei, drei, vier, fünf, zehn, 15, 20, 25, 30, 35, 40, 45, 50, 55 Minuten). Es kann hingegen auch möglich sein, dass sich der zeitliche Verlauf über eine Dauer von mehr als einer Stunde erstreckt oder über mehrere Tage hinweg.

In einigen Fällen kann das Bestimmen eines Degradationsfortschritts nicht nur als eine absolute Feststellung (nämlich, dass eine Degradation eingetreten ist) erfolgen, sondern insbesondere kann auch eine z.B. stufenweise Feststellung erfolgen, wie weit der Degradationsfortschritt bereits fortgeschritten ist. Auf diese Weise kann z.B. eine Aussage dahingehend erfolgen, dass der Stromrichter z.B. 10 %, 20 %, 30 %, 40 %, 50 %, 60 %, 70 %, 80 %, 90 %, 99 % seiner erwarteten Lebenszeit bereits erreicht hat, was als Ausgangspunkt dafür benutzt werden kann zu entscheiden, ob ein Austausch des Stromrichters erfolgen soll.

Die Referenzamplitude kann zumindest teilweise auf in der Vergangenheit bestimmten Amplituden für analog erfasste zeitliche Verläufe der Regelungsgröße und deren (systematischer) Zuordnung zu einem Degradationsfortschritt der zu charakterisierenden Last hervorgehen. Dies kann eine direkte Zuordnung eines Degradationsfortschritts zu einer, bei diesem Degradationsfortschritt vorliegenden Amplitude, ermöglichen.

In einigen Fällen kann sich durch eine Degradation der Last ein mit dem Betrieb der Last assoziierter Parameter wie z.B. ein Eingangsstrom bzw. eine Eingangsspannung, welcher von dem Stromrichter und/oder dem Zwischenkreis der Last zur Verfügung gestellt wird, ergeben. Dies kann sich in einem Ansteigen oder Abfallen des Ausgangsstroms und/oder der Ausgangsspannung des Stromrichters niederschlagen. Diese Veränderung des Ausgangsstroms und/oder der Ausgangsspannung kann sich auf ein Bestreben des Reglers, welcher dazu konfiguriert sein kann, den Ausgangsstrom und/oder die Ausgangsspannung auf einem konstanten Wert zu halten, auswirken. Dies kann sich z.B. in einer Veränderung der Regelungsgröße niederschlagen, wenn diese dazu verwendet wird, den Ausgangsstrom und/oder die Ausgangsspannung zu stabilisieren.

Der bestimmte Degradationsfortschritt kann einem Anwender z.B. in Textform und/oder graphisch und/oder als gesprochener Inhalt über eine Benutzerschnittstelle (z.B. ein Display, ein Tablet, etc.) bereitgestellt werden.

Auf diese Weise kann in effizienter Weise ein Funktionsspektrum des Condition Monitorings von einer alleinigen Charakterisierung eines Stromrichters auf eine Charakterisierung einer mit dem Stromrichter verbundenen Last erweitert werden und somit aus dem Überwachen eines mit einem Stromrichter assoziierten Parameters auf mit dem Stromrichter verbundene Lasten geschlossen werden und dadurch letztlich ein Bestimmen eines Degradationsfortschritts dieser Last erreicht werden. Ferner kann das Computer-implementierte Verfahren kostengünstig zu implementieren sein, da es bevorzugt Software-basiert bereitgestellt werden kann und z.B. bereits ausgelieferte Stromrichter entsprechend nachgerüstet werden können.

Gemäß einer Ausführungsform kann die Last ein elektrisches Antriebsmittel, eine Kombination aus einem Widerstand und einer Induktivität, ein Kabel, ein Filter und/oder ein Stromnetz sein.

Durch die Kombination des Widerstands und der Induktivität kann sich eine RL-Last ergeben.

Wird die Last als Kabel bereitgestellt, so kann es ermöglicht werden, eine Degradationsbestimmung des Kabels zu ermöglichen, wie dies z.B. bei einem Kabelbruch (z.B. vollständig oder einzelner Adern des Kabels) auftreten kann.

Das Stromnetz kann ein Stromnetz mit einer Frequenz von 50 Hz und einer Netzspannung von 230 V sein. Alternativ kann das Stromnetz auch ein Stromnetz mit einer Frequenz von 60 Hz und einer Spannung von 110 V sein.

Auf diese Weise kann ein effizientes Condition Monitoring für eine Vielzahl von auf einen Stromrichter und/oder einen Zwischenkreis folgenden Lasten bereitgestellt werden.

Gemäß einer weiteren Ausführungsform kann die Regelungsgröße ein Proportional-, P-, und/oder ein Integral-, I-, Anteil einer PI-Regelung und/oder ein durch einen Fehlerspeicher bereitgestellter Wert sein.

Der I-Anteil und/oder der P-Anteil eines betreffenden PI-Reglers kann so bereitgestellt werden, dass sich dieser jeweils aus einer Multiplikation eines Fehlersignals (d.h. einer Differenz zwischen einer Soll-Größe und einer Ist-Größe der Ausgangsspannung und/oder des Ausgangsstroms) mit einem vorbestimmten P- oder I-Wert ergibt. Bei dem P- oder I-Wert handelt es sich bevorzugt um einen Skalar. In einigen Fällen kann, die mit der Regelung assoziierte zumindest eine Zustandsgröße auch aus einer Summe des I-Anteils und des P-Anteils hervorgehen.

Der Ausgabewert des Fehlerspeichers kann mit einem Repetitive Control Reglers assoziiert sein. Das Konzept eines Repetitive Control Reglers kann darauf basieren, dass für eine bestimmte Differenz zwischen Soll-Wert und Ist-Wert (und/oder für eine bestimmte Steigung des zu regelnden Signals) bereits bekannt ist, welche Regelungsgröße (z.B. welche Stellspannung) verwendet werden kann, um die bestimmte Differenz zu minimieren bzw. zu Nullen. Auf diese Weise kann auch für höherfrequente Signalkomponenten, welche z.B. durch den I-Anteil einer PI-Regelung (z.B. auf Grund dessen integrierenden Verhaltens) nicht ausreichend ausgeregelt werden können, eine ausreichende Regelung ermöglicht werden kann.

Basierend auf dem Vergleichen kann nicht nur ein Bestimmen eines Degradationsfortschritts des Stromrichters erfolgen (da so z.B. eine Abweichung in der Ausgangsspannung und/oder dem Ausgangsstrom bestimmt werden kann), welche durch eine PI-Regler und/oder Fehlerspeicher-basierte Regelung bis zu einem gewissen Degradationsfortschritt ausgeregelt bzw. kompensiert werden kann, sondern zusätzlich oder alternativ auch ein Degradationsfortschritt des elektrischen Antriebsmittels selbst bestimmt werden kann. Dies kann dadurch erreicht werden, dass sich bei Voranschreiten der Degradation der Last, dessen Eingangsstrom- bzw. dessen Eingangsspannung verändern kann, was entsprechend durch den (vorgeschalteten) Stromrichter bis zum einem gewissen Degradationsfortschritt der Last kompensiert werden kann (z.B. durch Anpassen des Ausgangsstroms und/oder der Ausgangsspannung des Stromrichters, so dass eine erforderliche respektive Eingangsspannung bzw. ein respektiver Eingangsstrom an der Last bereitgestellt werden kann).

Auf diese Weise kann das Funktionsspektrum des Condition Monitoring von einem ggf. auf ein Bestimmen eines Degradationsfortschritts eines Stromrichters auch auf ein Bestimmen einer auf den Stromrichter (und/oder einer auf einen Zwischenkreis) folgenden Last erweitert werden, indem lediglich auf Parameter zurückgegriffen wird, welche auf den Stromrichter (und/oder den Zwischenkreis) beschränkt sind. Somit kann auf die Implementierung weiterer, dedizierter Hardware verzichtet werden (da lediglich solche Größen verwendet werden, welche während des Betriebs des Stromrichters und/oder des Zwischenkreises ohnehin anfallen) und ein effizientes Condition Monitoring bereitgestellt werden. Somit kann insgesamt ein verbessertes Condition Monitoring ermöglicht werden, ohne eine Zunahme der Systemkomplexität in Kauf nehmen zu müssen.

Gemäß einer weiteren Ausführungsform kann das Bestimmen der Amplitude ferner ein Bestimmen einer Amplitude eines Gleichanteils, einer 1. Harmonischen, einer 2. Harmonischen und/oder einer 6. Harmonischen umfassen.

Dies kann das Bestimmen eines Degradationsfortschritts basierend auf einer Vielzahl von Indikatoren, welche aus dem erfassten zeitlichen Verlauf hervorgehen, ermöglichen. Insbesondere kann dies ein Ermitteln eines Degradationsfortschritt, welcher unterschiedliche Ursachen haben kann, unterstützen, da sich z.B. einige Degradationsursachen lediglich in einigen höheren Harmonischen (z.B. nur 1. Harmonischen und/oder der 2. Harmonischen und/oder der 6. Harmonischen) niederschlagen, nicht jedoch in allen Harmonischen.

Das Bestimmen einer Veränderung der vorgenannten Größen (allein für sich betrachtet oder in Kombination) kann so z.B. als Indikator für Asymmetrien bezogen auf einen elektrischen Winkel eines Drehstrom- bzw. Wechselstromsystems herangezogen werden.

Die Bestimmung der höheren Harmonischen kann Aufschluss geben über einen Degradationszustand des Stromrichters (und/oder eines Halbleitermoduls davon), verwendeter Sensorik (z.B. Temperatursensoren, Schwingungssensoren, etc.) sowie den Degradationszustand eines Netzfilters.

Gemäß einer weiteren Ausführungsform kann das Computer-implementierte Verfahren ferner ein Erfassen eines mit der Last assoziierten Parameters umfassen, wobei der Parameter eine Temperatur der Last, eine Drehzahl eines elektrischen Antriebsmittels, ein Rotorlagewinkel eines elektrischen Antriebsmittels und/oder eine Umgebungstemperatur der Last ist sowie ein Bestimmen des Degradationsfortschritts der Last basierend auf dem Vergleichen und dem erfassten Parameter.

Unter einem mit der Last assoziierten Parameter kann ein Parameter verstanden werden, welcher nicht unmittelbar mit der Regelung einer Ausgangsspannung und/oder eines Ausgangsstroms des Stromrichters und/oder des Zwischenkreises assoziiert ist.

Unter der Temperatur der Last kann z.B. eine Innen- und/oder Außentemperatur eines elektrischen Antriebsmittels verstanden werden, wenn die Last als elektrisches Antriebsmittel bereitgestellt ist. Unter einer Umgebungstemperatur der Last kann eine Temperatur der Umgebung verstanden werden, in welcher sich die Last befindet.

Unter einem Rotorlagewinkel kann ein Winkel eines Rotors eines elektrischen Antriebsmittels relativ zu einer vordefinierten Rotorstellung verstanden werden.

Gemäß einer weiteren Ausführungsform kann der Stromrichter und/oder der Zwischenkreis Teil eines netzseitigen Stromrichtersystems sein.

In einigen Fällen kann der Stromrichter bzw. der Zwischenkreis so bereitgestellt werden, dass dieser eine Einspeisung einer erzeugten elektrischen Leistung in das Stromnetz vornehmen kann (z.B. durch eine derartige Anpassung der erzeugten Leistung, so dass diese den Erfordernissen des Stromnetzes genügt (z.B. bzgl. Frequenz, Spannung, etc.).

Auf diese Weise kann eine Überwachung eines Degradationsfortschritts in einem Stromnetz ermöglicht werden.

Gemäß einer weiteren Ausführungsform kann das Computer-implementierte Verfahren ferner ein Erfassen einer Vielzahl zeitlicher Verläufe sowie ein Bestimmen einer jeweiligen Amplitude der zumindest einen Harmonischen für jeden der erfassten zeitlichen Verläufe umfassen. Das Computer-implementierte Verfahren kann ferner ein Bestimmen einer Varianz der bestimmten Amplituden sowie ein Bestimmen des Degradationsfortschritts zumindest teilweise basierend auf der bestimmten Varianz umfassen.

Aus der Varianz kann so z.B. Information über die Stärke des Netzes (d.h. ob dieses als stark oder schwach anzusehen ist) abgeleitet werden.

Ein schwaches Netz kann sich z.B. dann ergeben, wenn durch einen begrenzten Kurzschlussstrom eines Stromrichters das Verhältnis von Kurzschlussstrom zu Netzimpedanz sinkt.

In einigen Fällen kann sich die Vielzahl erfasster zeitlicher Verläufe aus Verläufen zusammensetzen, welche in äquidistanten Zeitabständen erfasst wurden. Die erfassten zeitlichen Verläufe können jeweils eine gleiche zeitliche Länge aufweisen. In einigen Fällen kann zumindest einer der erfassten zeitlichen Verläufe eine zeitliche Länge aufweisen, welche sich von den verbleibenden zeitlichen Verläufen unterscheidet.

Auf diese Weise kann z.B. effizient festgestellt werden, ob z.B. ein Stromnetz ein unerwünschtes Flicker-Verhalten (z.B. dann, wenn die bestimmte Varianz einen vorbestimmten Schwellenwert der Varianz überschreitet) aufweist, wie dieses z.B. bei schwachen Netzen ausgeprägt sein kann.

Gemäß einer weiteren Ausführungsform kann das Computer-implementierte Verfahren ferner ein Bestimmen einer Phase, welche mit der höheren Harmonischen assoziiert ist, sowie ein Vergleichen der Phase mit einer Referenzphase umfassen. Ferner kann das Computer-implementierte Verfahren ein Bestimmen des Degradationsfortschritts der Last basierend auf dem Vergleichen der Amplitude und dem Vergleichen der Phase umfassen.

In einigen Fällen kann z.B. für sequentiell erfasste zeitliche Verläufe je eine Phasenlage der erfassten zeitlichen Verläufe relativ zueinander bestimmt werden.

Auf diese Weise kann das Bestimmen des Voranschreitens einer Degradation einer Last nicht nur alleinig auf einen Vergleich von Amplituden gestützt werden, sondern zusätzlich eine Phaseninformation mit einbeziehen. Dies kann die Vorhersagegenauigkeit des Degradationsfortschritts erhöhen und/oder kann die Bestimmung eines Degradationsfortschritts ermöglichen, welcher auf einer Degradationsursache basiert, welche sich z.B. nicht in einer entsprechenden Amplitudenveränderung manifestiert, sondern sich z.B. auf eine Phase niederschlägt. Somit kann das Computer-implementierte Verfahren zum Bestimmen eines Degradationsfortschritts einer Last effizient und kostengünstig weiter verbessert werden.

Gemäß einer weiteren Ausführungsform kann die Regelung des Stromrichters, wenn die Last ein Stromnetz ist, konfiguriert sein, Blindleistung zur Verfügung zu stellen, asymmetrische Belastungen auszuregeln und/oder eine Frequenzstabilisierung durchzuführen.

Unter einer Blindleistung kann vorliegend eine Energie verstanden werden, welche von dem Regler (z.B. durch in Induktivitäten des Reglers gespeicherter Energie) aufgebracht werden kann und dem Stromnetz zugeführt werden kann. In einigen Fällen kann die in den Induktivitäten des Reglers gespeicherte Energie von dem Stromnetz aufgenommen worden sein.

Das zur Verfügung stellen von Blindleistung kann z.B. vorteilhaft sein, wenn von dem Stromnetz Teilnehmer zugeschaltet oder weggeschaltet werden. Ebenfalls kann das zur Verfügung stellen von Blindleistung vorteilhaft sein, wenn eine Energiequelle dem Stromnetz zugeschaltet oder von diesem weggeschaltet wird.

Unter einer Frequenzstabilisierung kann vorliegend eine Stabilisierung der Frequenz des in das Stromnetz einzukoppelnden Stroms verstanden werden. Dies kann z.B. dann vorteilhaft sein, wenn die Last ein Stromnetz ist und festgestellt wurde, dass sich die Degradation auf eine Frequenz des Stromnetztes ausgewirkt hat und damit ggf. zu einer Abweichung der Frequenz von 50 Hz (alternativ von 60 Hz) geführt hat. Somit kann durch den Regler einer derartigen Abweichung zumindest teilweise entgegengewirkt werden.

Auf diese Weise können die Erkenntnisse aus dem Bestimmen eines Degradationsfortschritts der Last auch dazu verwendet werden, eine verbesserte Einspeisung von elektrischer Energie in ein Stromnetz bereitzustellen. Dies kann einen netzdienlichen Betrieb des Stromrichters unterstützen.

Gemäß einer weiteren Ausführungsform kann der Stromrichter und/oder der Zwischenkreis Teil einer Photovoltaikanlage oder einer Windkraftanlage sein.

Dies kann ein Überwachen eines Degradationsfortschritts einer Einspeisung von durch die Photovoltaikanlage und/oder von durch die Windkraftanlage erzeugter elektrischer Leistung in ein Stromnetz ermöglichen.

Dies kann ein Bestimmen eines Degradationsfortschritts solcher Lasten (bzw. Komponenten davon) ermöglichen, welche im Normalbetrieb z.B. schwer erreichbar sind (z.B., wenn die Windkraftanlage als Offshore-Park implementiert ist).

Gemäß einer weiteren Ausführungsform kann der Stromrichter ein 3-phasiger 2-Level Wechselrichter sein, wobei der Stromrichter zumindest ein Halbleitermodul, bevorzugt sechs Halbleitermodule umfassen kann und wobei das zumindest eine Halbleitermodul bevorzugt ein Bipolartransistor mit isolierter Gate Elektrode, IGBT, oder ein SiC- metal-oxide-semiconductor field-effect transistor, MOSFET, sein kann.

In einigen Fällen kann der Stromrichter ein Halbleitermodul, zwei, drei, vier, fünf, sechs, sieben, acht, neun, zehn oder mehr Halbleitermodule umfassen.

Es sei angemerkt, dass die hierin genannten Aspekte der Erfindung nicht auf IGBTs oder MOS-FETs als Halbleitermodule beschränkt sind, sondern dass Aspekte der Erfindung auch auf andere Halbleitermodule, welche hierin nicht explizit beschrieben werden, angewandt werden können.

In einigen Fällen kann der Stromrichter als eine Drehstrombrückenschaltung bereitgestellt werden.

Dies kann eine besonders kompakte und kostengünstige Implementierung eines Stromrichters ermöglichen

Gemäß einem zweiten Aspekt der vorliegenden Erfindung wird ein Computerprogrammprodukt vorgeschlagen, umfassend Befehle, die bei der Ausführung des Programms durch einen Computer diesen veranlassen, das Verfahren wie hierin beschrieben auszuführen.

In einigen Fällen kann das Computerprogrammprodukt z.B. in eine Antriebssteuerungssoftware des elektrischen Mittels integriert werden. In einigen Fällen können zumindest auszuführende Rechenoperationen (z.B. das Bestimmen der Abweichung und/oder einer Degradationsursache und/oder eines Degradationsfortschritts) von einer vom Stromrichter und/oder vom elektrischen Antriebsmittel getrennten Entität (z.B. eines Serversystems) getrennt sein. Auf diese Weise können ggf. rechenintensive Operationen von einer dediziert verwendeten Hardware ausgeführt werden.

Ein Computerprogrammprodukt, wie z.B. ein Computer-programm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computer-programm-Mittel erfolgen.

Gemäß einem dritten Aspekt der vorliegenden Erfindung wird eine Computer-implementierte Vorrichtung zum Bestimmen eines Degradationsfortschritts einer auf einen Stromrichter und/oder Zwischenkreis folgenden Last vorgeschlagen. Die Computer-implementierte Vorrichtung kann eine Erfassungseinheit zum Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist sowie eine erste Bestimmungseinheit zum Bestimmen einer Amplitude zumindest einer höheren Harmonischen einer Grundschwingung des erfassten zeitlichen Verlaufs umfassen. Ferner kann die Computer-implementierte Vorrichtung eine Vergleichseinheit zum Vergleichen der Amplitude mit einer Referenzamplitude umfassen, wobei die Referenzamplitude mit einem bekannten Degradationsfortschritt der Last assoziiert ist sowie eine zweite Bestimmungseinheit zum Bestimmen des Degradationsfortschritts der Last basierend auf dem Vergleichen.

Die jeweilige Einheit, zum Beispiel jede der Erfassungseinheit, der Bestimmungseinheiten, der Vergleichseinheit kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Gemäß einer Ausführungsform kann die Computer-implementierte Vorrichtung ferner eine Ausführungseinheit zum Ausführen des Computerprogrammprodukts wie hierin beschrieben und/oder eine weitere Ausführungseinheit zum Ausführen des Verfahrens wie ebenfalls hierin beschrieben, umfassen.

Die Ausführungseinheit kann z.B. als Computer, Prozessor, Field Programmable Gate Array (FPGA) oder eine Kombination davon vorgesehen sein.

Gemäß einem vierten Aspekt der vorliegenden Erfindung wird ein System zum Bestimmen eines Degradationsfortschritts einer auf einen Stromrichter und/oder Zwischenkreis folgenden Last vorgeschlagen Das System kann das Computerprogrammprodukt wie hierin beschrieben umfassen. Ferner kann das System eine Computer-implementierte Vorrichtung wie hierin beschrieben umfassen.

Das Computerprogrammprodukt kann in der Computer-implementierten Vorrichtung enthalten sein. In alternativen Beispielen kann das Computerprogramm auch in einer von der Computer-implementierten Vorrichtung entfernt vorgehaltenen Einheit enthalten sein. In letzterem beispielhaft genannten Fall kann die Computer-implementierte Vorrichtung über ein Netzwerk (z.B. ein lokales Netzwerk oder das Internet) oder eine USB-Verbindung auf das Computerprogrammprodukt zugreifen

Es sei darauf hingewiesen, dass das hierin beschriebene Bestimmen eines Degradationsfortschritts nicht nur auf eine auf den Stromrichter bzw. einen Zwischenkreis folgende Last beschränkt ist, sondern in analoger Weise auch dazu verwendet werden kann, ein Bestimmen eines Degradationsfortschritts des Stromrichters und/oder des Zwischenkreises selbst vorzunehmen.

Die für die vorgeschlagene Vorrichtung beschriebenen Ausführungsformen und Merkmale gelten für das vorgeschlagene Verfahren entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Insbesondere sei angemerkt, dass das oben beschriebene Verfahren bzw. die oben beschriebene Vorrichtung, das oben beschriebene Computerprogrammprodukt sowie das System nicht auf Stromrichter und/oder elektrische Antriebsmittel beschränkt ist, sondern auch in anderen industriellen Kontexten Anwendung finden kann.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1A-1C    zeigen einen Querschnitt durch einen IGBT (Fig. 1A) sowie mögliche Degradationsursachen eines Stromrichters (Fig. 1B und 1C);

Fig. 2    zeigt ein exemplarisches System, welches ein Zusammenwirken eines Stromrichters in einem möglichen erfindungsgemäßen Kontext zeigt;

Fig. 3    zeigt ein exemplarisches Ersatzschaltbild einer Drehstrombrückenschaltung;

Fig. 4       zeigt ein exemplarisches $\alpha\beta$-Diagramm;

Fig. 5       zeigt einen exemplarischen Systemflussplan;

Fig. 6       zeigt einen exemplarischen Systemflussplan;

Fig. 7       zeigt exemplarische Ereigniswolken zum Bestimmen eines Degradationszustands einer auf einen Stromrichter (und/oder Zwischenkreis) folgenden Last;

Fig. 8       zeigt exemplarische Diagramme zum Bestimmen eines Degradationszustands einer auf einen Stromrichter (und/oder Zwischenkreis) folgenden Last;

Fig. 9       zeigt ein Ablaufdiagramm eines exemplarischen Computer-implementierten Verfahrens;

Fig. 10       zeigt eine exemplarische Computer-implementierte Vorrichtung; und

Fig. 11       zeigt ein exemplarisches System.

In den Figuren sind gleiche oder funktionsgleiche Elemente mit denselben Bezugszeichen versehen worden, sofern nichts anderes angegeben ist.

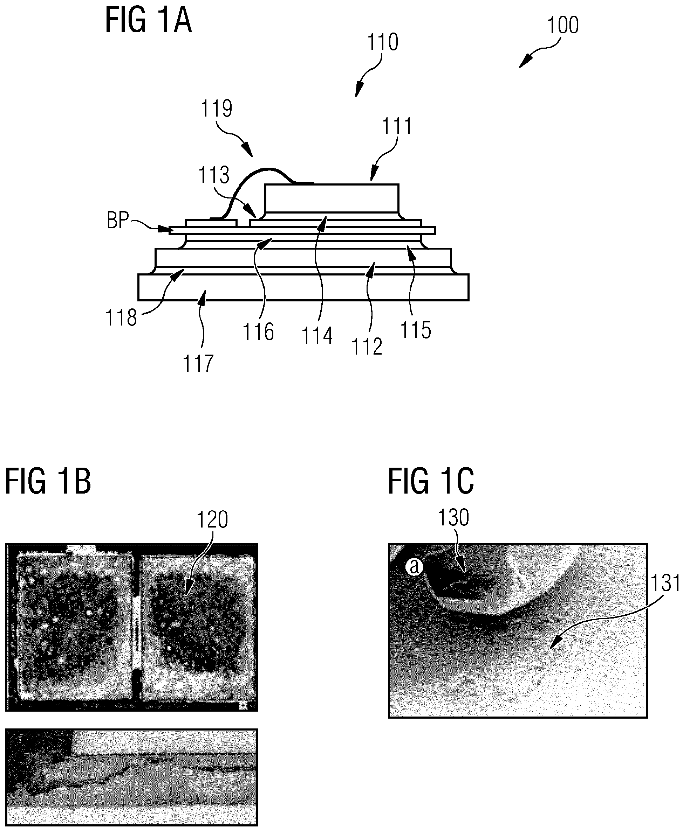

Fig. 1 zeigt einen exemplarischen Querschnitt durch einen IGBT 110, wie dieser z.B. in einem Stromrichter bzw. Umwandler enthalten sein kann.

Unter einem Stromrichter werden vorliegend Vorrichtungen verstanden, welche z.B. Wechselstrom in Gleichstrom umwandeln (Gleichrichter) oder Vorrichtungen, welche einen Gleichstrom in einen Wechselstrom umwandeln (Wechselrichter). Ferner kann unter einem Stromrichter auch ein Umrichter verstanden werden, welcher z.B. als Frequenzumrichter fungieren kann und z.B. eine Änderung einer Wechselstromfrequenz bewirken kann.

IGBT besteht aus einem Chip 111, welcher auf einer Basisplatte 112 angeordnet ist. Zwischen dem Chip 111 und der Basisplatte 112 kann eine erste Kupferschicht 113 angeordnet sein, um eine optimale Wärmeleitung zwischen dem Chip 111 und der Basisplatte 112 zu ermöglichen.

Chip 111 kann durch eine erste Lötzinnschicht 114 an der Kupferschicht 113 angebracht sein. Ferner kann die Basisplatte 112 über eine zweite Lötzinnschicht 115 und eine zweite Kupferschicht 116 mit der ersten Kupferschicht 113 verbunden sein.

Basisplatte 112 kann oberhalb einer Kühlplatte 117 angeordnet sein. Zwischen der Basisplatte 112 und der Kühlplatte 117 kann eine Wärmeleitpasteschicht 118 vorgesehen sein.

Ferner kann eine Oberseite des Chips 111 über einen Bonddraht 119 mit einer Stromversorgung (in Fig. 1 nicht abgebildet) verbunden sein.

Fig. 1B zeigt ferner eine mögliche Degradation eines Stromrichters (Ciappa, M.: "Selected failure mechanisms of modern power modules", Microelectronics Reliability, Vol. 42, Issues 4-5, 2002), welche z.B. durch eine Degradation einer Lötverbindung 120 hervorgerufen werden kann. Derartige Fehler in Lötverbindungen können z.B. durch (thermische) Risse im Lot hervorgerufen werden und/oder durch eine Ablösung der Lötverbindung (z.B. auch durch ein Ablösen eines Bonddrahts von der Oberseite des Chips 112 oder einer Stromversorgung). Eine Degradation einer Lötverbindung kann zu einer schlechteren elektrischen Kontaktierung führen und damit zu einer schlechteren Übertragung elektrischer Energie zum Betrieb von z.B. einem IGBT 110. Dies kann ferner zu einer Erhöhung des thermischen Widerstands führen und damit zu einer Änderung einer Durchlassspannung des IGBT, was zu einer unerwünschten Erwärmung des IGBT führen kann und damit eine Degradation des IGBT 110 weiter vorantreiben kann.

Fig. 1C zeigt eine weitere mögliche Degradation des Stromrichters (Ciappa, M.: "Selected failure mechanisms of modern power modules", Microelectronics Reliability, Vol. 42, Issues 4-5, 2002), welche z.B. durch eine Ablösung des Bonddrahtes 130 von einer Stromversorgung 131 hervorgerufen werden kann. In einem derartigen Fall kann z.B. eine Kontaktfläche zwischen dem Bonddraht 130 und der Stromversorgung 131 durch die Ablösung des Bonddrahtes 130 verkleinert werden. Dies kann zu einer Erhöhung des Widerstands der leitenden Verbindung zwischen z.B. einem IGBT und einer darunterliegenden Stromversorgung, verstanden werden.

Dieser erhöhte Widerstand muss z.B. durch eine Ausgangsstromregelung des IGBT 110 kompensiert werden. Dies kann schließlich zu einer Erwärmung des IGBT 110 beitragen und damit dessen Degradation weiter vorantreiben.

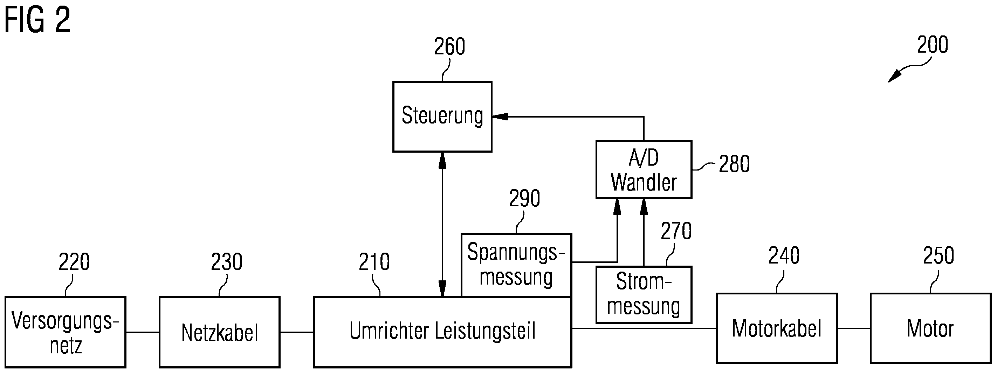

Fig. 2 zeigt ein exemplarisches System 200, welches ein Zusammenwirken eines Stromrichters (auch Umrichter) in einem möglichen erfindungsgemäßen Kontext zeigt.

Unter einem Stromrichter werden vorliegend Vorrichtungen verstanden, welche z.B. Wechselstrom in Gleichstrom umwandeln (Gleichrichter) oder Vorrichtungen, welche einen Gleichstrom in einen Wechselstrom umwandeln (Wechselrichter). Ferner kann unter einem Stromrichter auch ein Umrichter verstanden werden, welcher z.B. als Frequenzumrichter fungieren kann und z.B. eine Änderung einer Wechselstromfrequenz bewirken kann.

Das System 200 umfasst einen Umrichter (Leistungsteil) 210. Der Umrichter 210 wird von einem Versorgungsnetz 220 über ein Netzkabel 230 eingangsseitig mit Strom versorgt.

Ausgangsseitig kann der Umrichter 210 über ein Motorkabel 240 mit einem Motor 250 verbunden sein.

Umrichter 210 kann sich ferner mittels Steuerung 260 in einem geschlossenen Regelkreis befinden, welcher konfiguriert sein kann einen Ausgangsstrom des Umrichters 210 konstant zu halten.

Dies kann dadurch erreicht werden, dass ein Ausgangsstrom des Umrichters 210 durch eine Strommessung 270 gemessen wird (z.B. durch Messen eines um ein Kabel (z.B. Motorkabel 240) hervorgerufenen Magnetfelds). Das Resultat der Strommessung 270 kann eine zum Ausgangsstrom proportionale Spannung (z.B. proportionale Ausgangsspannung) sein, welche einem A/D Wandler 280 zugeführt werden kann.

A/D Wandler 280 kann dazu eingerichtet sein, die analoge Ausgangsspannung zu digitalisieren und damit in ein digitales Messsignal umzuwandeln.

Bevorzugt erfüllt die Abtastrate des A/D Wandlers 280 zumindest das Nyqvist-Kriterium. In einigen beispielhaften Fällen, wie hierin beschrieben, kann jedoch auch eine Überabtastung des Ausgangsstroms mittels A/D Wandler 280 vorgenommen werden.

In einigen Fällen kann auch eine dedizierte Spannungsmessung 290 (z.B. eine direkte Ausgangsspannung) vorgesehen sein. In einem derartigen beispielhaften Anwendungsfall kann der A/D Wandler 280 auch direkt die betreffende Ausgangsspannung abtasten.

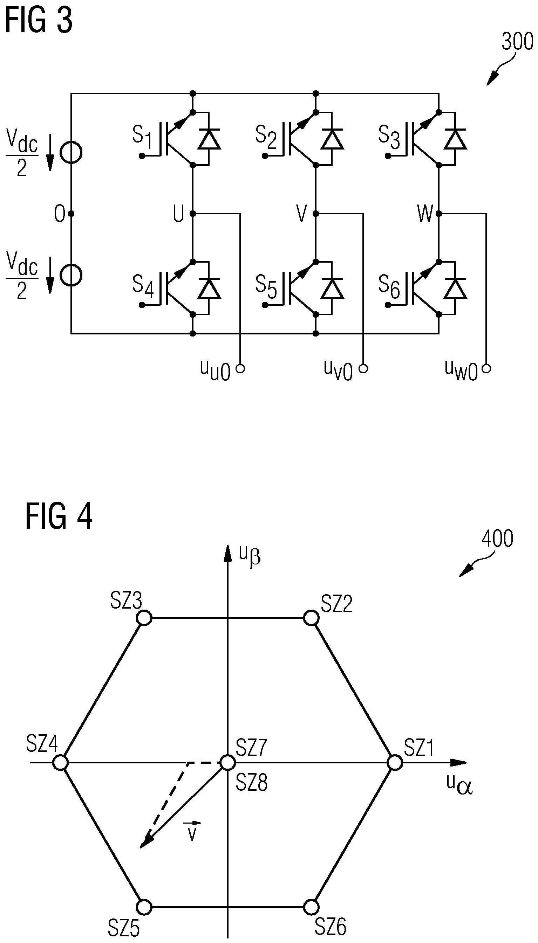

Fig. 3 zeigt ein exemplarisches Ersatzschaltbild einer Drehstrombrückenschaltung 300 gemäß Aspekten der vorliegenden Erfindung.

Drehstrombrückenschaltung 300 umfasst drei in einer oberen Hälfte der Drehstrombrückenschaltung 300 angeordnete Halbleitermodule $S_1$-$S_3$.

Drehstrombrückenschaltung 300 umfasst drei in einer unteren Hälfte der Drehstrombrückenschaltung 300 angeordnete Halbleitermodule $S_4$-$S_6$.

Alle oder zumindest einige der Halbleitermodule $S_1$-$S_6$ können als IGBTs bereitgestellt werden.

Drehstrombrückenschaltung 300 wird vorliegend mit einer Gleichspannungsquelle $V_{DC}$ betrieben.

Drehstrombrückenschaltung 300 umfasst ferner drei Klemmen $u_{u0}$, $u_{v0}$ und $u_{w0}$, über die eine 3-phasige Last an einen Ausgang der Drehstrombrückenschaltung 300 angeschlossen werden kann.

Ein Einschalten der oberen Halbleitermodule $S_1$-$S_3$ kann dazu führen, dass die drei Klemmen $u_{u0}$, $u_{v0}$ und $u_{w0}$ mit einem positiven Zwischenkreispotential verbunden werden, wobei die Klemmen $u_{u0}$, $u_{v0}$ und $u_{w0}$ jeweils an den entsprechenden Knoten U, V, W abgegriffen werden.

Analoges gilt für ein negatives Zwischenkreispotential, wenn die jeweiligen in der unteren Hälfte der Drehstrombrückenschaltung 300 angeordneten Halbleitermodule $S_4$-$S_6$ eingeschaltet werden.

Um einen Kurzschluss zu vermeiden, ist es von Bedeutung, die in der oberen Hälfte der Drehstrombrückenschaltung 300 angeordneten Halbleitermodule $S_1$-$S_3$ nicht gleichzeitig mit den in der unteren Hälfte der Drehstrombrückenschaltung 300 angeordneten Halbleitermodule $S_4$-$S_6$ zu betreiben. Ein paralleler Betrieb von Halbleitermodulen einer der beiden Hälften ist hingegen möglich. In einem derartigen Fall entscheidet das Stromvorzeichen einer jeweiligen Phase, ob ein negatives oder positives Zwischenkreispotential mit den Klemmen $u_{u0}$, $u_{v0}$ und $u_{w0}$ verbunden ist.

Während einer mechanischen und/oder elektronischen Periode (Fundamentalperiode) können sich Szenarien ergeben, in welchen Gruppen von Halbleitermodulen für gewisse Zeitabschnitte für längere Zeiten beschaltet werden, als dies für andere Gruppen von IGBTs der Fall sein kann. Dies kann sowohl in einer "two level" (zwei Regelungsstufen des Ausgangsstroms) als auch in einer "multilevel" (mehrere Regelungsstufen des Ausgangsstroms) Topologie auftreten.

Da Halbleitermodule meist gruppenweise beschaltet werden, können sich so zeitliche Sektoren ergeben, sodass ein von dem Stromrichter ausgegebenes Signal aus einer Superposition der jeweils beschalteten Halbleitermodulen ergibt. Eine Degradation eines Halbleitermoduls kann zu einer Veränderung der Perioden(-dauer, z.B. im Bereich einer Halbperiode oder Viertelperiode) führen, was durch eine einen Ausgang des Stromrichters regelnde Elektronik ausgeglichen werden muss und sich somit z.B. in einem P- und/oder I-Signals eines PI-Reglers widerspiegeln kann.

Es sei ferner angemerkt, dass jede einzelne Phase zwei verschiedene diskrete Schaltzustände (ein/aus) annehmen kann. Wird von drei Phasen ausgegangen, so ergeben sich insgesamt $2^3 = 8$ Schaltzustände.

Ein sequentielles Beschalten der Halbleitermodule der Drehstrombrückenschaltung 300 führt zu einem Durchlaufen von insgesamt sechs Schaltzuständen, welche in Form eines $\alpha\beta$-Diagramms 400 dargestellt werden können, wie in Fig. 4 dargestellt.

Fig. 4 zeigt ein $\alpha\beta$-Diagramm 400 umfassend einen Vektor $\vec{v}$ welcher in der $\alpha\beta$-Ebene rotiert und mit Hilfe der Schaltzustände SZ1-SZ6 nachgebildet wird, wobei jeder der Schaltzustände SZ1-SZ6 dem Beschalten eines respektiven Halbleitermoduls $S_1$-$S_6$ entspricht.

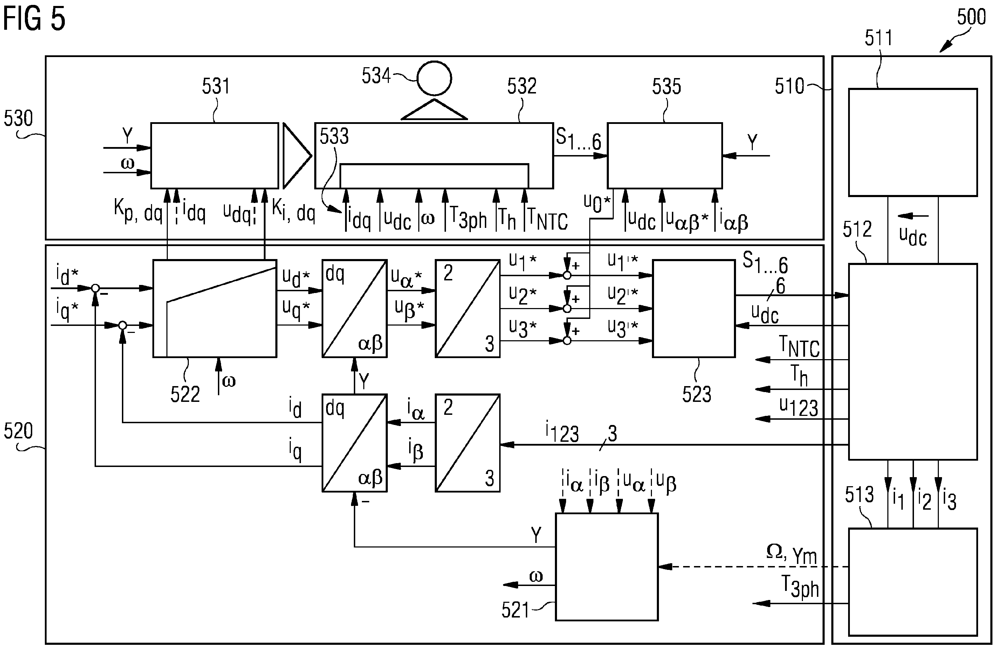

Fig. 5 zeigt einen Signalflussplan 500 eines Zusammenwirkens eines physischen Systems 510, eines Regelungssystems 520 sowie eines parallel zum Regelungssystems 520 geschalteten Condition Monitoring Systems 530.

Das physikalische System 510 kann dabei ein DC-System 511 umfassen. DC-System 511 kann zum Einsatz zusammen mit einem Stromrichter für ein elektrisches Antriebssystem bereitgestellt sein, welcher in der Regel eine Zwischenkreisspannung über eine Einspeisung zur Verfügung stellt (Diodengleichrichter, AFE). Grundsätzlich ist jedoch auch jede andere DC-Quelle bzw. -Last implementierbar, wie z.B. eine DC-Ladesäule oder ein Photovoltaik-Feld, etc.

Die von dem DC-System 511 zur Verfügung gestellte Spannung $U_{DC}$ kann an einen Converter (Stromrichter) 512 bzw. eine entsprechende Leistungselektronik zur Verfügung gestellt werden. Der Stromrichter 512 kann dabei z.B. als eine Drehstrombrückenschaltung (z.B. die Drehstrombrückenschaltung 300) bereitgestellt werden. Der Stromrichter 512 bzw. die Leistungselektronik besteht dabei nicht alleinig aus der Drehstrombrückenschaltung, sondern kann auch Sensoren zur Strommessung, Temperaturüberwachung, Spannungsmessung, etc. umfassen. Diese Sensoren können zusätzlich in das datenbasierte Condition Monitoring eingebunden werden.

Mit einem Ausgang des Stromrichters 512 ist schließlich ein drei-phasiges AC-System 513 verbunden, welches z.B. durch die drei Phasen $i_1$, $i_2$ und $i_3$ mit dem Stromrichter 512 verbunden sein kann, welche durch den Konverter 512 erzeugt wurden.

Das drei-phasige AC-System 513 kann als ein Elektromotor bzw. eine Asynchronmaschine oder eine Synchronmaschine bereitgestellt werden.

In einigen Fällen kann das drei-phasige AC-System 513 jedoch auch ein drei-phasiges elektrisches Netz sein.

Regelungssystem 520 kann auf einer feldorientierten Regelung (auch Vektorregelung) basieren. Bei der feldorientierten Regelung werden sinusförmige - oder als weitgehend sinusförmig angenommene - Wechselgrößen (beispielsweise Wechselspannungen und Wechselströme) nicht direkt in ihrem zeitlichen Momentanwert, sondern in einem um den Phasenwinkel innerhalb der Periode bereinigten Momentanwert geregelt. Zu diesem Zweck werden die erfassten Wechselgrößen jeweils in ein mit der Frequenz der Wechselgrößen rotierendes Koordinatensystem übertragen. Innerhalb des rotierenden Koordinatensystems ergeben sich dann aus den Wechselgrößen Gleichgrößen, auf die alle üblichen Verfahren der Regelungstechnik angewandt werden können.

In einer möglichen Implementierung kann eine Transformation von Strommesswerten in ein (Rotor-) Flussbasiertes Koordinatensystems (dq-System) erfolgen. Ferner kann sich daran eine entkoppelte Regelung des feldbildenden Stroms (ausgedrückt durch die d-Achse) und des drehmomentbildenden Stroms (ausgedrückt durch die q-Achse) anschließen. Für jede der beiden Koordinatenachsen (d und q) kann ein entsprechender PI-Regler vorgesehen werden.

Ein Transformationswinkel des flussbasierten Koordinatensystems kann je nach Anwendungsfall direkt gemessen oder über eine Modellierung geschätzt werden, wie dies durch Flusswinkelbestimmungseinheit 521 ermöglicht werden kann.

Bei Asynchronmaschinen kann das Spannungs-/Strommodell auf Messgrößen basieren, bei Synchronmaschinen kann eine direkte Messung der Rotorlage erfolgen, bei einem elektrischen Netz kann ein Spannungsmodell bzw. eine Phasenregelschleife (engl.: *phase locked loop* (PLL)) basierend auf Messgrößen implementiert werden.

Durch einen Regelungsblock 522 kann aus einer Regelabweichung (z.B. durch einen Soll-/Istwertvergleich) eine Sollspannung berechnet werden, welche vom Stromrichter 512 ausgeben werden muss, um die Regelabweichung zu minimieren, idealerweise auf null zu setzen. Die so bestimmte Sollspannung kann aus dem flussbasierten Koordinatensystem rücktransformiert werden und als Spannungssollwerte für die drei Phasen des betrachteten Systems verwendet werden.

Innerhalb des Modulators 523 können aus den Sollspannungen zusammen mit einer gemessenen Zwischenkreisspannung die Schaltzeitpunkte für die Leistungshalbleiter berechnet und als Ansteuersignale an den Stromrichter übergeben werden.

Das Condition Monitoring 530 kann derart bereitgestellt werden, dass es die verfügbaren Mess- und/oder Reglergrößen auswerten kann. Dies kann z.B. einen P- und/oder I-Teil der beiden PI-Regler umfassen, gemessene Ströme und/oder gemessene Spannungen. Diese können jeweils als zeitlicher Verlauf erfasst worden sein.

In einem ersten Schritt können in einer Fenster- bzw. Analyseeinheit 531 die verfügbaren Daten mittels eines auf eine elektrische oder mechanische Periode abgestimmten Fensters (z.B. durch Falten mit einer Fensterfunktion) vorbearbeitet werden. Hieran anschließen kann sich das Ausführen einer Frequenzanalyse, z.B. das Ausführen einer FFT, ein Berechnen einer Fourier-Serie, etc. Hieraus können dazugehörige Fourierkoeffizienten (Amplitude und Phasenlage) der im Signal des erfassten zeitlichen Verlaufs enthaltenen Oberwellen.

Das Ausführen einer derartigen Frequenzanalyse kann zyklisch und damit wiederholt ausgeführt werden. Dies kann ein Überwachen einer möglichen Änderung der Fourierkoeffizienten im Zeitverlauf ermöglichen.

Basierend hierauf kann mittels einer Condition Monitoring Überwachungseinheit 532 ein Bestimmen erfolgen, z.B. durch Vergleichen der Fourierkoeffizienten mit Referenz-Fourierkoeffizienten, ob ein Voranschreiten des Degradationsfortschritts eingetreten ist.

Zusätzlich können in das datenbasierte Condition Monitoring weitere Umweltbedingungen 533 mit einfließen (z.B. eine Luftfeuchtigkeit, Umgebungstemperatur, etc.). Bei gleichbleibenden Umweltbedingungen kann aus einer Veränderung der Fourierkoeffizienten so auf ein Voranschreiten einer Degradation geschlossen werden, wodurch letztendlich auf einen beginnenden Fehler im betrachteten System geschlossen werden kann. In anderen Worten, typische Fehlerbilder in Drehstrombrückenschaltungen können typischerweise zu entsprechenden Signaturen in den untersuchten höheren Harmonischen führen.

Basierend hierauf kann Überwachungseinheit 532 dann einen Gesundheitszustand 534 (engl.: *state of health* (SOH)) des betrachteten Systems bestimmen.

Es sei angemerkt, dass das Condition Monitoring 530 physisch in dem physischen System 510 enthalten sein kann (z.B. als Teil des drei-phasigen AC-Systems 513). Alternativ kann es auch möglich sein, dass das Condition Monitoring 530 in einer entfernten Entität (z.B. als Cloud-Dienst, als Edge-Gerät, etc.) vorgehalten wird, welche z.B. mit dem physischen System 510 und/oder dem Regelungssystem 520 in Kommunikationsverbindung steht.

An Überwachungseinheit 532 kann sich (optional) ferner eine Nullspannungsanpassungseinheit 535 anschließen. Diese kann basierend auf den durch Überwachungseinheit 532 bereitgestellten Daten eine Nullspannung derart bestimmen, so dass diese eine Leitzeit zumindest eines Halbleitermoduls (z.B. eines Halbleitermoduls, welches als degradiert angesehen wird) herabsetzt und damit die Lebenszeit des betreffenden Halbleitermoduls weiter verlängert werden kann. Die Nullspannung kann auf das Ausgabesignal des Regelungsblocks 522 aufaddiert werden und schließlich dem Modulator 532 zugeführt werden, um ein Ansteuersignal zu bestimmen, welches schließlich dem Stromrichter 512 zugeführt werden kann, so dass eine Anpassung der Leitzeit des betreffenden Halbleitermoduls (ggf. auch mehrerer Halbleitermodule) erfolgen kann.

Wird eine Phasenlage der betrachteten höheren Harmonischen bestimmt, so kann eine Fehlerlokalisation dahingehend erfolgen, welches der Halbleitermodule möglicherweise von einem Fehler bzw. Ausfall (und damit mit einem Voranschreiten der Degradation) betroffen ist, wie oben bereits beschrieben.

Das Anlegen einer Nullspannung kann zu einer Erhöhung oder Absenkung einer Aussteuerung des Stromrichters auf allen Phasen führen, bei der jedoch eine an Lastklemmen anliegende verkettete Spannung gleichbleibt. Die Nullspannung kann bevorzugt so gewählt werden, dass die Leitzeit für ein Halbleitermodul von Interesse verlängert wird, im Vergleich zu Halbleitermodulen, denen im vorliegenden Kontext eine geringere Bedeutung beigemessen wird. Je nach Polarität des Ausgangsstroms einer Phase wird die Nullspannung dann positiv oder negativ gewählt. Die auf diese Weise erhaltene (zweite) Summenspannung kann dann einem Modulator zugeführt werden und basierend auf einer Raumzeigermodulation oder einem trägerbasierten Modulationsverfahren in ein entsprechendes Ansteuersignal für die zumindest sechs Halbleitermodule überführt werden.

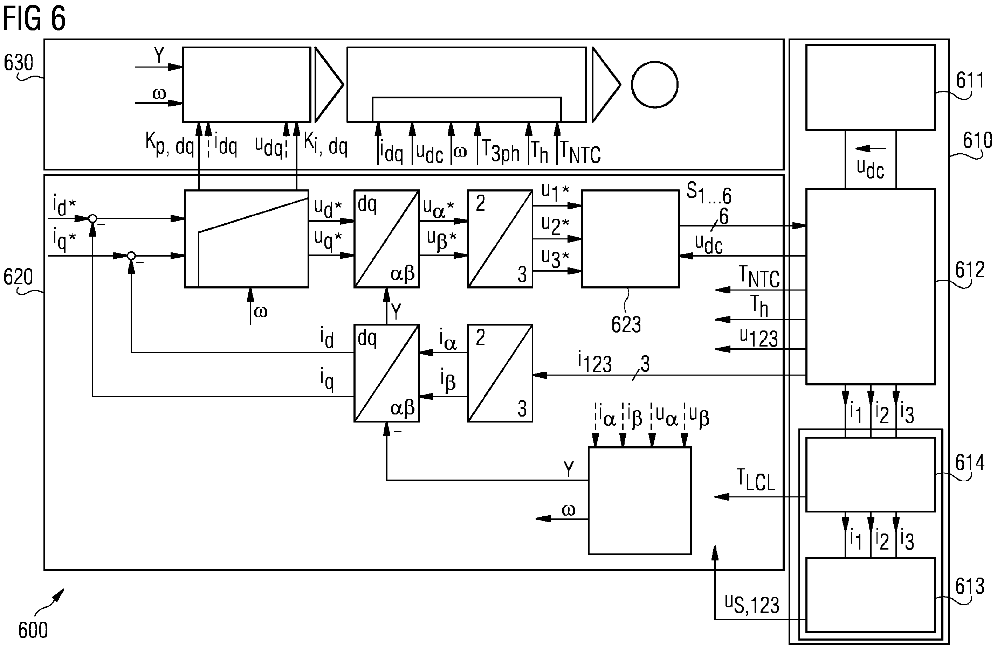

Fig. 6 zeigt einen weiteren Signalflussplan 600 eines Zusammenwirkens eines physischen Systems 610, eines Regelungssystems 620 sowie eines parallel zum Regelungssystems 620 geschalteten Condition Monitoring Systems 630.

Das physische System 610 kann dabei bereitgestellt und konfiguriert sein wie das mit Bezug zu Fig. 5 beschriebene physische System 510, wobei dem drei-phasigen System 613 (im Gegensatz zu dem drei-phasigen System 513 aus Fig. 5) ein drei-phasiger LCL-Filter 614 vorgeschaltet wurde.

Das Regelungssystem 620 kann bereitgestellt und konfiguriert sein wie das mit Bezug zu Fig. 5 beschriebene Regelungssystem 520.

Das Condition Monitoring System 630 kann bereitgestellt und konfiguriert sein wie das mit Bezug zu Fig. 5 beschriebene Condition Monitoring System 530, wobei das Regelungssystem 630 vorliegend auf die in Fig. 5 (als optional) dargestellte Nullspannungseinheit 535 verzichtet.

Folglich verzichtet das Regelungssystem 620 auch auf ein Zuführen einer angepassten Nullspannung an den Modulator 623 (gegenüber der in Fig. 5 dargestellten Implementierung).

Stromrichter 612 (welcher implementiert sein kann wie der Stromrichter 512 aus Fig. 5), kann dazu verwendet werden, ein Condition Monitoring, d.h. ein Bestimmen, ob ein Degradationszustand einer auf den Stromrichter 612 folgenden Last aufgetreten ist, bereitzustellen. Vorliegend kann die Last als der drei-phasige LCL-Filter 614 bereitgestellt werden.

In einer bevorzugten Implementierung kann für das Bestimmen, ob eine Degradation des LCL-Filters 614 aufgetreten ist, insbesondere ein Integralanteil einer durch das Regelungssystem 620 bereitgestellten PI-Regelung benutzt werden. In dem Integralanteil kann in einigen Fällen insbesondere eine langfristige Veränderung des LCL-Filters 614 (bzw. eines Netzes) widergespiegelt werden.

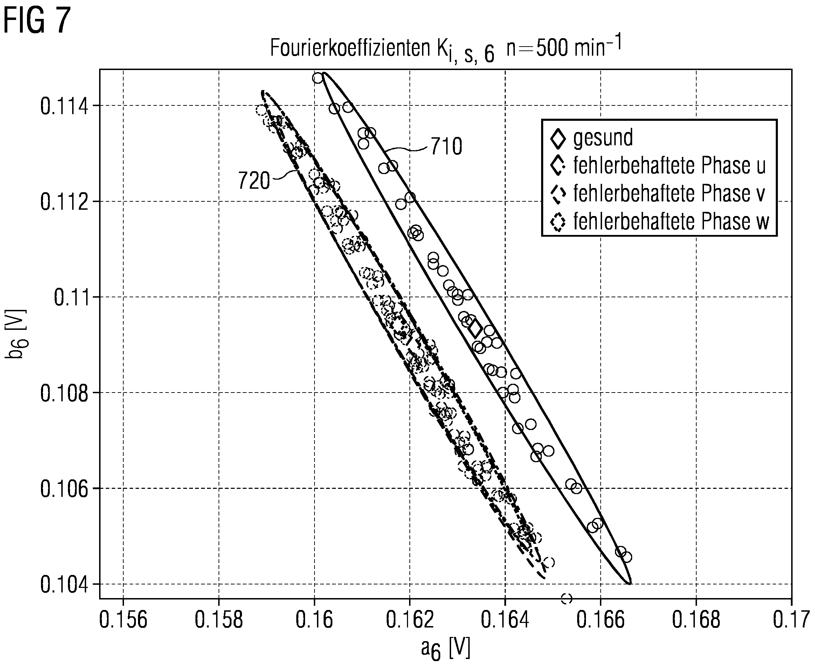

Fig. 7 zeigen exemplarische Ereigniswolken, welche sich aus einem Auftragen von Fourierkoeffizienten $b_6$ gegen $a_6$ für eine Vielzahl (erster) zeitlicher Verläufe ergeben. Die zugrundeliegenden erfassten zeitlichen Verläufe beziehen sich auf eine Umdrehungsgeschwindigkeit des elektrischen Antriebsmittels von 500 Umdrehungen pro Minute.

Die Fourierkoeffizienten $a_k$ bzw. $b_k$ mit $k \in \mathbb{N}$ können aus einem Anwenden einer Fouriertransformation (z.B. einer Fast Fourier Transformation (FFT)) auf einen (ersten) erfassten zeitlichen Verlauf einer Ausgangsspannung und/oder eines Ausgangsstroms des Stromrichters hervorgehen. Die Fourierkoeffizienten $a_k$ bzw. $b_k$ können derart normiert sein, dass sie gemäß Gleichung 1 zur Rekonstruktion des erfassten zeitlichen Verlaufs $f(t)$ beitragen. Der zeitliche Verlauf $f(t)$ kann durch eine Darstellung durch eine Fourierreihe daher wie folgt beschrieben werden:

$$f(t) \sim \frac{a_0}{2} + \sum_{k=1}^{\infty} \left( a_k \cos\left(\frac{2\pi}{T} kt\right) + b_k \sin\left(\frac{2\pi}{T} kt\right) \right)$$

Gleichung 1

In Gleichung 1 beschreibt $a_0$ einen statischen Beitrag zum Signal (z.B. einen Gleichanteil), $T$ eine Periodendauer einer betrachteten Frequenzkomponente k zum Signal f(t).

Ereigniswolke 710 beschreibt dabei einen Zustand, zu welchem der Stromrichter als gesund anzusehen ist, d.h. zu welchem noch keine (wesentliche) Degradation des Stromrichters aufgetreten ist. Ereigniswolke 710 erstreckt sich über einen Bereich von -0,162 V bis 0,166 V für $a_6$ sowie über einen Bereich von 0,104 V bis 0,114 V für $b_6$.

Ferner zeigt Fig. 7 mehrere sich überlappende Ereigniswolken (angedeutet durch Ereigniswolke 720) für einen fehlerhaften Zustand der Last (d.h. einem Zustand, welcher mit einem Voranschreiten des Degradationszustands der Last assoziiert werden kann). Die betreffende Ereigniswolke 720 erstreckt sich vorliegend in einem Bereich von ca. 0,159 V bis ca. 0,165 für $a_6$ sowie in einem Bereich von 0,104 V bis 0,114 V für $b_6$.

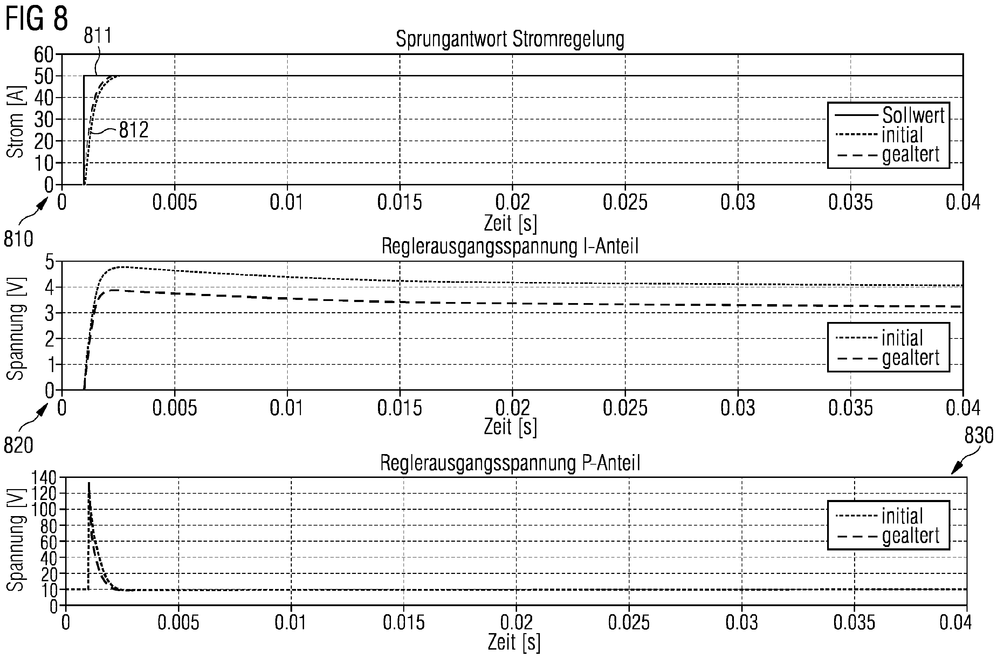

Fig. 8 zeigt ein exemplarisches Anwendungsbeispiel für die Bestimmung eines Degradationszustands einer auf einen Stromrichter (und/oder Zwischenkreis) folgenden Last.

Diagramm 810 zeigt einen exemplarischen Verlauf eines Stroms in A, welcher als Ausgangsstrom eines Stromreglers gemessen werden kann, aufgetragen gegen die Zeit für einen erwarteten Sollverlauf 811. Ferner zeigt Diagramm 810 einen initialen Stromverlauf 812 (d.h. unmittelbar nach Implementierung des Stromnetzes bzw. eines Netzfilters, welches/welcher als Last einem Condition Monitoring unterzogen werden soll). Ferner zeigt Diagramm 810 auch den exemplarischen Verlauf des Stroms, wie dieser im Falle eines gealterten Stromnetzes auftreten kann (gestrichelt).

Wie aus Diagramm 810 ersichtlich, entspricht der erwartete Sollwertverlauf einer Stufenfunktion, d.h. einem sprunghaften Anstieg des Stroms von 0 A auf 50 A. Dieser Sollverlauf wird durch ein reales System durch den initialen Stromverlauf 812 widergespiegelt, welcher den Sollverlauf in einer abgerundeten Form wiedergibt (für einen Zeitabschnitt von weniger als 4 ms). Für eine Zeit > 5 ms, nimmt der Stromverlauf einen konstanten Wert von ca. 50 A an.

Im Falle des Vorliegens eines Degradationsfortschritts kann exemplarisch der initiale Stromverlauf 812 nachgebildet werden, jedoch um einen Offset (z.B. um weniger als 1 A) zu größeren Strömen hin verschoben.

Auf diese Weise kann, von dem initialen Stromverlauf 812 ausgehend, durch das Bestimmen, dass eine Verschiebung des Stromflusses eingetreten ist, auf ein Voranschreiten eines zugrundeliegenden Degradationsfortschritts geschlossen werden.

Diagramm 820 zeigt einen exemplarischen Verlauf einer Reglerausgangsspannung in V (des Integral-Anteils eines PI-Reglers), wie diese z.B. einem Stromrichter zugeführt werden kann, um einen Ausgangsstrom (bzw. eine Ausgangsspannung) des Stromrichters auf einen gewünschten Sollwert zu regeln, aufgetragen gegen einen zeitlichen Verlauf.

Der durch das Diagramm 820 dargestellte Spannungsverlauf der Reglerausgangsspannung kann dazu verwendet werden, den Stromverlauf (wie in Diagramm 810) dargestellt auf einen konstanten Wert von z.B. 50 A zu regeln.

Diagramm 820 zeigt den Verlauf des Spannungsverlaufs für einen initialen Zustand (in welchem z.B. ein Stromnetz und/oder ein Netzfilter in einem nicht-degradierten Zustand vorliegt; durchgezogene Linien) sowie für einen degradierten Zustand (gestrichelte Linie).

Während der exemplarisch gezeigte Stromverlauf für den initialen Zustand zunächst von 0 V auf ca. 5 V ansteigt (für einen Zeitabschnitt von < 4 ms), folgt dieser exemplarisch etwa einem exponentiellen Abfallverhalten und geht für eine Zeit von > 25 ms in einen konstanten Spannungswert von ca. 4 V über.

Im Falle eines Vorliegens einer Degradation wird vorliegend der Verlauf des initialen Zustands nachgebildet, jedoch bei einer um ca. 0,9 V zu kleineren Spannungswerten hin verschobenen Spannung.

Diagramm 830 zeigt hingegen einen exemplarischen Verlauf einer Reglerausgangsspannung in V (des Proportional-Anteils eine PI-Reglers), wie diese z.B. einem Stromrichter zugeführt werden kann, um einen Ausgangsstrom (bzw. eine Ausgangsspannung) des Stromrichters auf einen gewünschten Sollwert zu regeln, aufgetragen gegen einen zeitlichen Verlauf.

Der durch das Diagramm 830 dargestellte Spannungsverlauf der Reglerausgangsspannung kann dazu verwendet werden, den Stromverlauf (wie in Diagramm 810) dargestellt auf einen konstanten Wert von z.B. 50 A zu regeln.

Diagramm 830 zeigt den Verlauf des Spannungsverlaufs für einen initialen Zustand (in welchem z.B. ein Stromnetz und/oder ein Netzfilter in einem nicht-degradierten Zustand vorliegt; durchgezogene Linien) sowie für einen degradierten Zustand (gestrichelte Linie).

Im vorliegend gezeigten Fall steigt der Spannungsverlauf sprunghaft von 0 V auf 130 V an, und folgt anschließend einem exponentiellen Abfallverhalten und nimmt für Zeiten > 4 ms einen konstanten Wert von nahezu 0 Van.

Ein Vorliegen einer Degradation kann sich vorliegend in einer Verschiebung der Reglerausgangsspannung während des Abfallverhaltens hin zu einer kleineren Spannung (z.B. um ca. 1 V) manifestieren, wobei ansonsten der qualitative Verlauf der Ausgangsspannungskurve, welche den initialen Zustand widerspiegelt, nachgebildet wird und damit qualitativ erhalten bleibt.

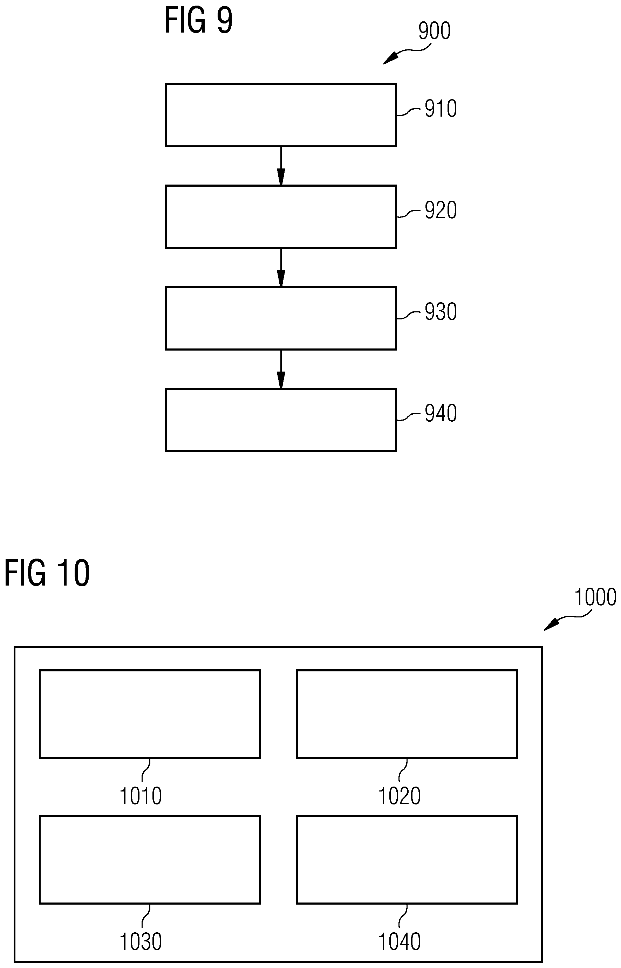

Fig. 9 zeigt ein Ablaufdiagramm eines exemplarischen Computer-implementierten Verfahrens 900 zum Bestimmen eines Degradationsfortschritts einer auf einen Stromrichter und/oder Zwischenkreis folgenden Last gemäß einem Aspekt der vorliegenden Erfindung.

In Schritt 910 erfolgt ein Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist.

In Schritt 920 erfolgt ein Bestimmen einer Amplitude zumindest einer höheren Harmonischen einer Grundschwingung des erfassten zeitlichen Verlaufs.

In Schritt 930 erfolgt ein Vergleichen der Amplitude mit einer Referenzamplitude, wobei die Referenzamplitude mit einem bekannten Degradationsfortschritt der Last assoziiert ist.

In Schritt 940 erfolgt ein Bestimmen des Degradationsfortschritts der Last basierend auf dem Vergleichen.

Fig. 10 zeigt eine exemplarische Computer-implementierte Vorrichtung 1000 zum Bestimmen eines Degradationsfortschritts eines Stromrichters gemäß einem Aspekt der vorliegenden Erfindung. Die Computer-implementierte Vorrichtung 1000 umfasst eine Erfassungseinheit 1010, eine erste Bestimmungseinheit 1020, eine Vergleichseinheit 1030 und eine zweite Bestimmungseinheit 1040.

Die Erfassungseinheit 1010 ist konfiguriert zum Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist.

Die erste Bestimmungseinheit 1020 ist konfiguriert zum Bestimmen einer Amplitude zumindest einer höheren Harmonischen einer Grundschwingung des erfassten zeitlichen Verlaufs.

Die Vergleichseinheit 1030 ist konfiguriert zum Vergleichen der Amplitude mit einer Referenzamplitude, wobei die Referenzamplitude mit einem bekannten Degradationsfortschritt der Last assoziiert ist.

Die zweite Bestimmungseinheit 1040 ist konfiguriert zum Bestimmen des Degradationsfortschritts der Last basierend auf dem Vergleichen.

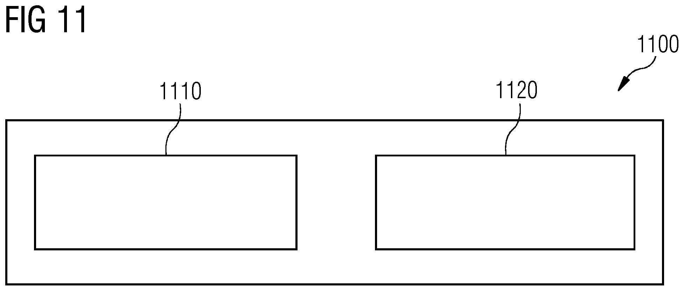

Fig. 11 zeigt ein exemplarisches System 1100 zum Bestimmen eines Degradationsfortschritts eines Stromrichters gemäß einem Aspekt der vorliegenden Erfindung. Das System 1100 beinhaltet eine Computer-implementierte Vorrichtung 1110 und ein Computerprogrammprodukt 1120.

Die Computer-implementierte Vorrichtung 1110 kann konfiguriert sein, wie hierin beschrieben.

Das Computerprogrammprodukt 1120 kann konfiguriert sein, wie hierin beschrieben.

Obwohl die vorliegende Erfindung anhand von Ausführungsbeispielen beschrieben wurde, ist sie vielfältig modifizierbar.

Unabhängig vom grammatikalischen Geschlecht eines bestimmten Begriffes sind Personen mit männlicher, weiblicher oder anderer Geschlechteridentität mit umfasst.

**Patentansprüche**

1. Computer-implementiertes Verfahren (900) zum Bestimmen eines Degradationsfortschritts einer auf einen Stromrichter und/oder Zwischenkreis folgenden Last, umfassend:

   Erfassen (910) eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist;
   Bestimmen (920) einer Amplitude zumindest einer höheren Harmonischen einer Grundschwingung des erfassten zeitlichen Verlaufs;
   Vergleichen (930) der Amplitude mit einer Referenzamplitude, wobei die Referenzamplitude mit einem bekannten Degradationsfortschritt der Last assoziiert ist; und
   Bestimmen (940) des Degradationsfortschritts der Last basierend auf dem Vergleichen.

2. Computer-implementiertes Verfahren nach Anspruch 1, wobei die Last ein elektrisches Antriebsmittel, eine Kombination aus einem Widerstand und einer Induktivität, ein Kabel, ein Filter und/oder ein Stromnetz ist.

3. Computer-implementiertes Verfahren nach einem der Ansprüche 1 oder 2, wobei die Regelungsgröße ein Proportional-, P-, und/oder ein Integral-, I-, Anteil einer PI-Regelung und/oder ein durch einen Fehlerspeicher bereitgestellter Wert ist.

4. Computer-implementiertes Verfahren nach einem der Ansprüche 1-3, das Bestimmen der Amplitude ferner umfassend:
Bestimmen einer Amplitude eines Gleichanteils, einer 1. Harmonischen, einer 2. Harmonischen und/oder einer 6. Harmonischen.

5. Computer-implementiertes Verfahren nach einem der Ansprüche 1-4, ferner umfassend:

Erfassen eines mit der Last assoziierten Parameters, wobei der Parameter eine Temperatur der Last, eine Drehzahl eines elektrischen Antriebsmittels, ein Rotorlagewinkel eines elektrischen Antriebsmittels und/oder eine Umgebungstemperatur der Last ist;
Bestimmen des Degradationsfortschritts der Last basierend auf dem Vergleichen und dem erfassten Parameter.

6. Computer-implementiertes Verfahren nach einem der Ansprüche 1-5, wobei der Stromrichter und/oder der Zwischenkreis Teil eines netzseitigen Stromrichtersystems ist.

7. Computer-implementiertes Verfahren nach einem der Ansprüche 1-6, ferner umfassend:

Erfassen einer Vielzahl zeitlicher Verläufe;
Bestimmen einer jeweiligen Amplitude der zumindest einen Harmonischen für jeden der erfassten zeitlichen Verläufe;
Bestimmen einer Varianz der bestimmten Amplituden; und
Bestimmen des Degradationsfortschritts zumindest teilweise basierend auf der bestimmten Varianz.

8. Computer-implementiertes Verfahren nach einem der Ansprüche 1-7, ferner umfassend:

Bestimmen einer Phase welche mit der höheren Harmonischen assoziiert ist;
Vergleichen der Phase mit einer Referenzphase; und
Bestimmen des Degradationsfortschritts der Last basierend auf dem Vergleichen der Amplitude und dem Vergleichen der Phase.

9. Computer-implementiertes Verfahren nach einem der Ansprüche 1-8, wobei die Regelung des Stromrichters, wenn die Last ein Stromnetz ist, konfiguriert ist, Blindleistung zur Verfügung zu stellen, asymmetrische Belastungen auszuregeln und/oder eine Frequenzstabilisierung durchzuführen.

10. Computer-implementiertes Verfahren nach einem der Ansprüche 1-9, wobei der Stromrichter und/oder der Zwischenkreis Teil einer Photovoltaikanlage oder einer Windkraftanlage ist.

11. Computer-implementiertes Verfahren nach einem der Ansprüche 1-10, wobei der Stromrichter ein 3-phasiger 2-Level Wechselrichter ist;

wobei der Stromrichter zumindest ein Halbleitermodul, bevorzugt sechs Halbleitermodule umfasst; und
wobei das zumindest eine Halbleitermodul bevorzugt ein Bipolartransistor mit isolierter Gate Elektrode, IGBT, oder ein SiC- metal-oxide-semiconductor field-effect transistor, MOSFET, ist.

12. Computerprogrammprodukt, umfassend Befehle, die bei der Ausführung des Programms durch einen Computer diesen veranlassen, das Verfahren nach einem der Ansprüche 1 - 11 auszuführen.

13. Computer-implementierte Vorrichtung (1000) zum Bestimmen eines Degradationsfortschritts einer auf einen Stromrichter und/oder Zwischenkreis folgenden Last, umfassend:

eine Erfassungseinheit (1010) zum Erfassen eines zeitlichen Verlaufs einer Regelungsgröße welche zur Regelung einer Ausgangsspannung und/oder eines Ausgangsstroms des Stromrichters und/oder des Zwischenkreises bestimmt ist und wobei die Ausgangsspannung und/oder der Ausgangsstrom zum Zuführen an die Last bestimmt ist;
eine erste Bestimmungseinheit (1020) zum Bestimmen einer Amplitude zumindest einer höheren Harmonischen einer Grundschwingung des erfassten zeitlichen Verlaufs;

eine Vergleichseinheit (1030) zum Vergleichen der Amplitude mit einer Referenzamplitude, wobei die Referenzamplitude mit einem bekannten Degradationsfortschritt der Last assoziiert ist; und

eine zweite Bestimmungseinheit (1040) zum Bestimmen des Degradationsfortschritts der Last basierend auf dem Vergleichen.

14. Computer-implementierte Vorrichtung nach Anspruch 13, ferner umfassend:

eine Ausführungseinheit zum Ausführen des Computerprogrammprodukts nach Anspruch 12; und/oder

eine weitere Ausführungseinheit zum Ausführen des Verfahrens nach einem der Ansprüche 1-11.

15. System (1100) zum Bestimmen eines Degradationsfortschritts eines Stromrichters, umfassend:

Computerprogrammprodukt (1110) nach Anspruch 12; und

Computer-implementierte Vorrichtung (1120) nach einem der Ansprüche 13 oder 14.

## FIG 1A

## FIG 1B

## FIG 1C

## FIG 2

EP 4 700 414 A1

## FIG 3

## FIG 4

FIG 5

FIG 6

EP 4 700 414 A1

FIG 7

Fourierkoeffizienten $K_{i, s, 6}$  $n=500$ min$^{-1}$

EP 4 700 414 A1

FIG 8

Sprungantwort Stromregelung

Reglerausgangsspannung I-Anteil

Reglerausgangsspannung P-Anteil

## FIG 9

900

910

920

930

940

## FIG 10

1000

1010

1020

1030

1040

FIG 11

1100

1110

1120

Europäisches Patentamt
European Patent Office
Office européen des brevets

# EUROPÄISCHER RECHERCHENBERICHT

Nummer der Anmeldung

EP 24 19 5582

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | KR 102 182 635 B1 (ELECTRIC CO LTD [KR]) 24. November 2020 (2020-11-24) * Absatz [0003] - Absatz [0041]; Abbildung 4 * ----- | 1-15 | INV. G01R31/42 H02M1/32 |
| A | US 9 880 228 B2 (WANK NORBERT H [US]; FRIEDMAN DAVID H [US]; INFINIREL CORP [US]) 30. Januar 2018 (2018-01-30) * Anspruch 1; Abbildung 1 * ----- | 1-15 | |
| A | OU SHUYU ET AL: "Semiconductor Devices Condition Monitoring Using Harmonics in Inverter Control Variables", 2023 25TH EUROPEAN CONFERENCE ON POWER ELECTRONICS AND APPLICATIONS (EPE'23 ECCE EUROPE), EPE ASSOCIATION, 4. September 2023 (2023-09-04), Seiten 1-8, XP034437345, DOI: 10.23919/EPE23ECCEEUROPE58414.2023.10264538 [gefunden am 2023-10-03] * das ganze Dokument * ----- | 1-15 | |

RECHERCHIERTE SACHGEBIETE (IPC)

G01R
H02M

Der vorliegende Recherchenbericht wurde für alle Patentansprüche erstellt

| Recherchenort | Abschlußdatum der Recherche | Prüfer |
|---|---|---|
| München | 29. Januar 2025 | O'Callaghan, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.....................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                    EP 24 19 5582

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-01-2025

| Im Recherchenbericht angeführtes Patentdokument | Datum der Veröffentlichung | Mitglied(er) der Patentfamilie | Datum der Veröffentlichung |
|---|---|---|---|
| KR 102182635      B1 | 24-11-2020 | KEINE | |
| US 9880228       B2 | 30-01-2018 | EP      2649717 A1<br>ES      2833080 T3<br>US   2013282313 A1<br>WO   2012082648 A1 | 16-10-2013<br>14-06-2021<br>24-10-2013<br>21-06-2012 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **CIAPPA, M.** Selected failure mechanisms of modern power modules. *Microelectronics Reliability*, 2002, vol. 42 (4-5)